# EUROPÄISCHE PATENTANMELDUNG

(11) **EP 2 128 634 A1**
(43) Veröffentlichungstag der Anmeldung: **02.12.2009**
(21) Anmeldenummer: 09006879.2
(22) Anmeldetag: 22.05.2009
(51) Int. Cl.: G01R 23/18, H04N 17/00

(54) **Rundfunk- und/oder Fernsignal-Meßgerät**

(30) Priorität: 26.05.2008 ES 200801619 P
(71) Anmelder: Sistemas Integrados de Servicios de Telecontrol, S.L., 15706 Santiago de Compostela (ES)
(72) Erfinder: Ledo Gaviero, Jose Luis, 15706 Santiago de Compostela (ES); Rey Juncal, Jose, 15706 Santiago de Compostela (ES); Loyacono Pardo, Gabriel, 15706 Santiago de Compostela (ES); Ucha Cuevas, Miguel Angel, 15706 Santiago de Compostela (ES); Perez Gonzalez, Fernando, 15706 Santiago de Compostela (ES); Mosquera Nartallo, Carlos, 15706 Santiago de Compostela (ES); Lopez Valcarce, Roberto, 15706 Santiago de Compostela (ES)
(74) Vertreter: Dosterschill, Peter

(57) **Zusammenfassung**

Die Erfindung betrifft ein Gerät (E) zum Messen von Rundfunk- und/oder TV-Signalen, das Messungen von verschiedenen TV-Signalarten, insbesondere von DVBT-, DVBC-, DVBS- und/oder DVBS2-Signalen, durchführt.
Erfindungsgemäß sind Visualisierungsmittel vorgesehen, die eine simultane Visualisierung eines radioelektrischen Spektrums von TV-Kanälen, insbesondere der DVBT-, DVBC-, DVBS- und/oder DVBS2-Signale, im Bereich zwischen 5 MHz und 2,5 GHz und weiterhin des Spektrums des eingestellten Signals und seiner Nachbarkanäle mit einer Bandbreite von 20 MHz für terrestrisches Band und 50 MHz für Satellitenband auf genau einer Sichtanzeige-Einheit (7) durchführen.

## Beschreibung

Die vorliegende Erfindung betrifft ein Gerät und ein Verfahren zum Messen von Rundfunk- und/oder Fernsehsignalen, das Messungen von verschiedenen TV-Signalarten, insbesondere von DVBT-, DVBC-, DVBS- und/oder DVBS2-Signalen ausführt und auf genau einer Sichtanzeige-Einheit simultan ein radioelektrisches Spektrum zwischen 5 MHz und 2,5 GHz und ein Spektrum von 20 MHz für terrestrisches Band und 50 MHz für Satellitenband zentriert im eingestellten Kanal anzeigt.

Die tragbaren Geräte, die zur Prüfung der TV- und Rundfunksignalqualität benutzt werden, haben gewöhnlich die Demodulation von Rundfunkkanälen zur Grundlage, die sich auf Spektralfrequenzen zwischen 5 MHz und 2,5 GHz befinden. Dieses Signal wird für die Messung verschiedener Parameter (C/N, BER, CBER usw.), die Messung der Qualität des Videosignals oder die Frequenzempfindlichkeit des eingestellten Kanals benutzt.

Bei den ersten Feldstärkemessern wurde die Spektralanalyse vertikal und stets ausschließend mit der Anzeige des eingestellten Kanals auf der Sichtanzeige dargestellt.

Die spektrale Belegung in einer kollektiven Verteilung (gemeinsame Telekommunikationsinfrastrukturen) wird immer größer, sowohl in der Zahl der benutzten Kanäle als auch der Kanalarten (analog, digital, COFDM, QAM, QPSK). Diese Vielfalt und Menge an Kanälen bedeutet gleichzeitig einen größeren Aufwand, sowohl bei der Messarbeit und -zeit, als auch bei der Prüfung der Qualität der Einrichtung und anschließenden Erstellung von Berichten zur Zertifizierung der Einrichtung.

Gegenwärtig belegt bei vielen gemeinsamen Telekommunikationsinfrastrukturen, neben einer hohen Belegungsdichte des Frequenzbands, das von der Regulierungseinheit zugewiesen ist, der Entwickler verschiedene Kanäle und nimmt eine Umverteilung vor, im Bestreben, die Benutzung der verfügbaren Bandbreite zu maximieren. Das Problem bei dieser intensiven Benutzung der Bandbreite tritt über die Überlagerungen zwischen verschiedenen Kanälen aufgrund der Beschaffenheit des Verteilungsnetzes (ein-kanalig, Mischer, Bandpassfilter usw.) oder die Verschiebung eines Tones auf eine nicht gewünschte Frequenz usw. auf.

Die Aufgabe der vorliegenden Erfindung ist es, ein Gerät und ein Verfahren der eingangs genannten Art zu schaffen, das dem Benutzer ein größeres Spektrum von Dienstleistungen ermöglicht.

Diese Aufgabe wird mit einem Messgerät wie in den Ansprüchen definiert gelöst.

Das erfindungsgemäße tragbare, mit Batterien gespeiste Gerät führt Messungen zum Kennzeichnen verschiedener TV-Signalarten, insbesondere von DVBT, DVBC, DVBS und DVBS2 durch und macht auf derselben Sichtanzeige simultan ein radioelektrisches Spektrum einer vom Benutzer ausgewählten Bandbreite zwischen 5 MHz und 2,5 GHz und das Spektrum des eingestellten Kanals und seiner Nachbarkanäle mit einer Auflösung von 20 MHz für terrestrisches Band und 50 MHz für Satellitenband sichtbar.

Das erfindungsgemäße Gerät weist den Vorteil auf, dass es in "Echtzeit" die gesamte Spektralinformation über den eingestellten Kanal und den Einfluss erhält, den die Nachbarkanäle und die anderen Bänder des radioelektrischen Spektrums, die von der Übertragung des TV-Signals benutzt sind, aufweisen kann, neben der Anzeige der für die Übertragung der Nachbarkanäle notwendigen Bandbreite, zusammen mit den Signalqualitätsmessungen entsprechend ihrer Beschaffenheit, d.h. abhängig vom Band und der genutzten Modulationsart. Die Qualitätsbestimmung des Signals ist für den Benutzer transparent, da als einziges die Einstellungsfrequenz oder der Einstellungskanal zu berücksichtigen ist, mit der daraus folgenden Verbesserung der Zeit und Verfügbarkeit des Geräts beim Kennzeichnen einer Einrichtung.

Die simultane Anzeige all dieser Information gibt dem Benutzer eine globale Perspektive des gesamten Prozesses und ermöglicht es ihm, Probleme bezüglich der intensiven Benutzung der verfügbaren Bandbreite, verschiedene Probleme im benutzten Verteilungsnetz und ihre möglichen Auswirkungen auf die Qualität des Signals oder Bilds zu erkennen.

Die Erfindung weist mehrere Vorteile auf.

Ein Beispiel eines Geräts zum Messen von Rundfunk- und/oder TV-Signalen, das Messungen von verschiedenen TV-Signalarten (DVBT, DVBC, DVBS und DVBS2) durchführt, ist **dadurch gekennzeichnet, dass** es auf derselben Sichtanzeige simultan ein radioelektrisches Spektrum von TV-Signalen (DVBT, DVBC, DVBS und DVBS2) zwischen 5 MHz und 2,5 GHz und ein detaillierteres Spektrum mit einer Bandbreite von 20 MHz für terrestrisches Band und 50 MHz für Satellitenband zentriert im eingestellten Kanal sichtbar macht, was ermöglicht, den Kanal und seine Nachbarkanäle zu untersuchen. Dies weist den Vorteil auf, die gleichzeitige Anzeige aller Kennzeichen des Kanals und die Wirkung des gesamten Bands des radioelektrischen Spektrums zu ermöglichen.

In einer weiteren Ausführungsform gemäß der Erfindung ist das Gerät zum Messen von Rundfunk- und/oder Fernsehsignalen durch einen HF-Block, einen Bandpassfilter, einen Analog-Digital-Umsetzer, ein digitales Verarbeitungsmodul einen Mikroprozessor und einen Speicher gebildet.

In einer anderen Ausführungsform gemäß der Erfindung weist das Messgerät ein Batteriesystem auf, das das Gerät versorgt. Dies bietet den Vorteil, seine Nutzung an Orten zuzulassen, an denen kein Anschluss an das Stromnetz besteht, wie etwa auf Dächern, Dachterrassen, Türmen usw.

Ein Beispiel eines Geräts zum Messen von Rundfunk- und/oder TV-Signalen, das Messungen von verschiedenen TV-Signalarten (DVBT, DVBC, DVBS und DVBS2) durchführt, ist **dadurch gekennzeichnet, dass** es auf derselben Sichtanzeige simultan ein radioelektrisches Spektrum von TV-Signalen (DVBT, DVBC, DVBS und DVBS2) zwischen 5 MHz und 2,5 GHz und ein detaillierteres Spektrum mit einer Bandbreite von 20 MHz für terrestrisches Band und 50 MHz für Satellitenband zentriert im eingestellten Kanal sichtbar macht, das es ermöglicht, den Kanal und seine Nachbarkanäle zu untersuchen.

In einem anderen Beispiel gemäß der Erfindung ist das Verfahren zum Messen von Rundfunk- und Fernsehsignalen **dadurch gekennzeichnet, dass** das Messverfahren zumindest die folgenden Schritte umfasst:
- Auswählen des Kanals und der eingegebenen Parameter durch den Benutzer,
- Auswählen der auszuführenden Art der Messungen,
- Einstellen des Kanals,
- Auswählen des Bezugspegels.
- Berechnen des vollständigen Spektrums gemäß SPAN (Breite des Visualisierungsbildschirms),
- Berechnen des Spektrums des Kanals.
- Simultanes Darstellen der gesamten Information auf derselben Sichtanzeige.

Das Gerät zum Messen von Rundfunk- und/oder Fernsehsignalen gemäß der Erfindung führt die simultane Anzeige eines radioelektrischen Spektrums zwischen 5 MHz und 2,5 GHz und die Anzeige eines Spektrums des Kanals und der Kanäle in "Echtzeit" ohne Verzögerungen oder progressive Aktualisierungen durch.
Das Gerät zum Messen von Rundfunk- und/oder Fernsehsignalen gemäß der Erfindung identifiziert den Messkanal und wählt die Parameter des folgenden, auf dem Band vorhandenen Kanals aus.

Im Folgenden ist auf Grundlage der Figuren ein nicht einschränkendes Beispiel einer Ausführung des Geräts gemäß der Erfindung beschrieben. Es zeigt:
- Figur 1: ein Schaubild des Geräts gemäß der Erfindung, und
- Figur 2: die Darstellung der Information in dem Gerät gemäß der Messung.

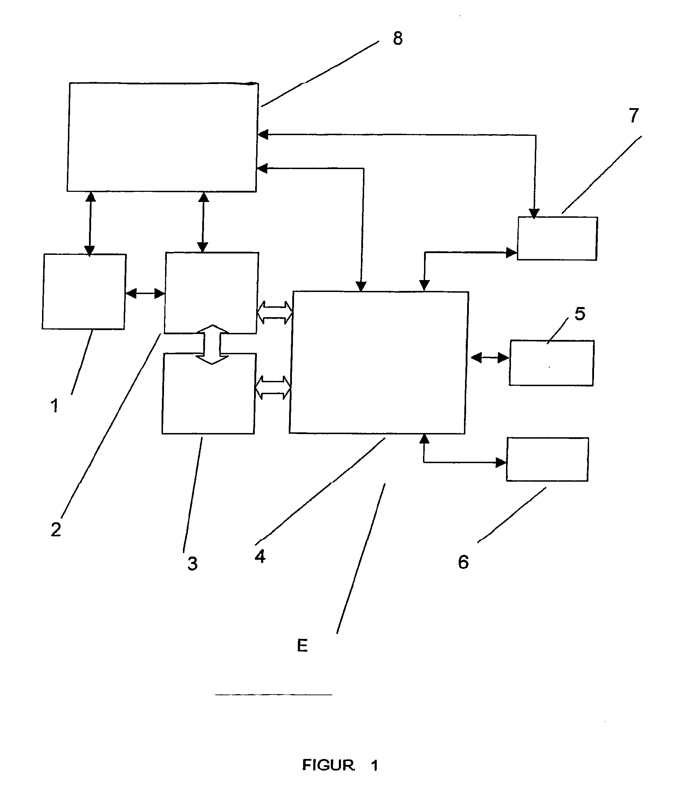

Wie aus Figur 1 ersichtlich, ist das Gerät E durch eine HF-Einheit 1, eine digitale Verarbeitungseinheit 2 , einen Speicher 3, einen Mikroprozessor oder Mikrocontroller 4, eine Benutzeroberfläche (Tastenfeld) 6, eine Sichtanzeige-Einheit 7, ein Batteriesystem 5 und einen Demodulator 8 gebildet.
Die HF-Einheit 1 erfasst das Eingangssignal (ein oder mehrere Fernsehkanäle insbesondere im Format DVBT, DVBC, DVBS und/oder DVBS2) und transformiert es auf ein anderes Frequenzband als das Eingangsband.

Die digitale Verarbeitungseinheit 2 berechnet die Spektraleigenschaften in einer Umgebung der eingestellten Frequenz und des gesamten Spektrums gemäß SPAN (Breite des Visualisierungs-Bildschirms) und sendet die Information an den Mikroprozessor 4. Dieser ist die zentrale Komponente des Verarbeitungssystems, da er die mathematische Berechnung mithilfe von schnellen Fourier-Transformationen (FFT) des numerischen Signals ermöglicht, das von dem Analog-Digital-Umsetzer bereitgestellt ist.

Der Demodulator 8 führt die korrekte Demodulation des HF-Signals durch und sendet die Information der durchgeführten Demodulation an den Mikroprozessor 4 und das Videosignal an den Anzeige-Einheit 7.

Der Mikroprozessor oder Mikrocontroller 4 ist der Steuerungskern des Geräts E und für die Verwaltung der anderen Elemente zuständig. Unter Benutzung eines im Speicher (3) geladenen Programms führt der Mikroprozessor (4) die beschriebenen Funktionen aus und stellt die Ergebnisse auf einer Sichtanzeige (7) dar, wo auf derselben Sichtanzeige simultan das Spektrum gemäß vom Benutzer ausgewählter SPAN zwischen 5 MHz und 2,5 GHz und das Spektrum in Zoom-Modus zentriert im eingestellten Kanal und den Nachbarkanälen mit einer Bandbreite von 20 MHz für terrestrisches Band und 50 MHz für Satellitenband angezeigt wird.

Eine Benutzeroberfläche 6 ermöglicht automatisiert das Steuern und Abrufen der Information des Messgeräts E zur Darstellung für den Benutzer oder ihre Übertragung an eine andere Vorrichtung.

Das Gerät weist außerdem ein Batteriesystem 5, das ebenfalls vom Mikroprozessor 4 verwaltet wird.

Die Messung wird derart mit digitalen Signalverarbeitungs- (DPS-) Techniken ausgeführt, dass das Signal nach seiner Bandpassfilterung auf der HF-Bandfrequenz in der HF-Einheit 1 auf ZF abgestimmt und unter Benutzung der digitalen Verarbeitungseinheit 2 in Echtzeit auf Frequenz, Zeit, Modulationsart usw. analysiert wird.

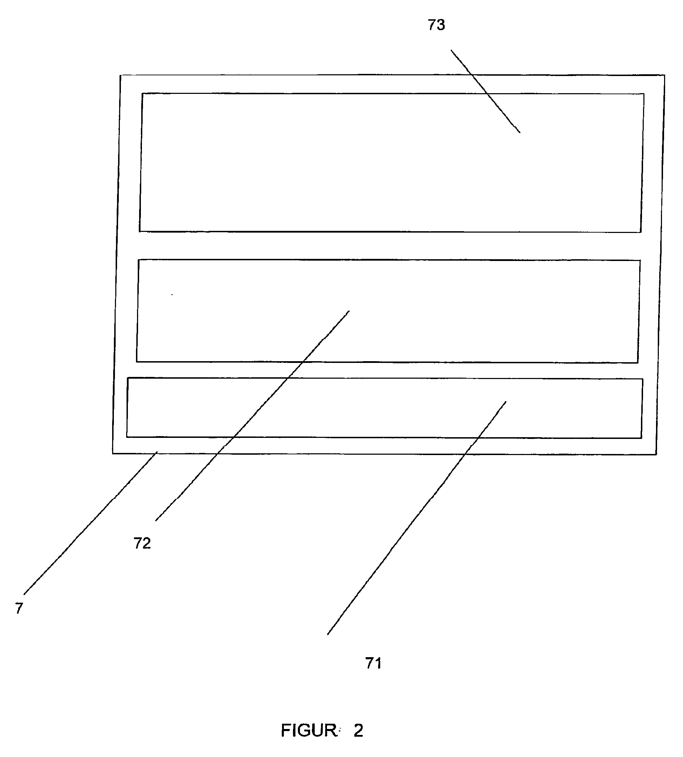

Figur 2 zeigt die Darstellung der gesamten Information simultan auf genau einer, also derselben Sichtanzeige-Einheit 7. Wie ersichtlich, ist auf dieser Sichtanzeige-Einheit 7 eine Information über den eingestellten Kanal und Messungen 71, die Spektraleigenschaften des eingestellten Kanals und der Nachbarkanäle mit einer Bandbreite von 20 MHz für terrestrisches Band und 50 MHz für Satellitenband 72 und das vollständige radioelektrische Spektrum gemäß ausgewählter SPAN-Parameter 73 (Breite des Visualisierungsbildschirms) sichtbar gemacht.

Das Messverfahren des Geräts beginnt mit der Auswahl der Frequenz oder des Kanals, die bzw. der eingestellt werden soll, und der Bandbreite, die spektral angezeigt werden soll, sowie des Referenzpegels seitens des Benutzers mithilfe der Benutzeroberfläche 6. Über diesen Wert wird die Anzeige auf der Sichtanzeige-Einheit 7 des vollständigen Spektrums und des im Kanal und seinen Nachbarkanälen zentrierten Spektrums durchgeführt.

Das Gerät führt das Messverfahren durch, das auf der sequenziellen Ausführung der folgenden Funktionen basiert:
Der Algorithmus basiert auf der sequenziellen Ausführung der folgenden Funktionen:
   - Beachtung der Auswahl des Kanals und der SPAN-Parameter (Parameter von Bildschirmbreiten), die angezeigt werden sollen und vom Benutzer eingegeben werden,
   - Auswahl der Untersuchungsart, die ausgeführt werden soll, im Spektrummodus unter Differenzierung zwischen analog und digital, sowie die Auswahl des Bezugspegels, der Bandbreite,
   - Das HF-Signal wird verarbeitet und eine Umsetzung auf Zwischenfrequenz (ZF) durchgeführt und findet Eingang in die Blöcke 2 und 8.
   - Unter Verwendung des vom Block 1 vorgesehenen Signals wird es gesampelt und durch den Block 2 unter Anwendung von digitalen Verarbeitungstechniken, wie etwa die FFT-Algorithmen, DFT, in Echtzeit auf digital umgesetzt. Diese Information wird im Block 3 gespeichert.
   - Der Block 4 führt die Steuerung des Blocks 1 zur Ausführung der Frequenzumsetzung der vom Benutzer ausgewählten Bandbreite in Sprüngen von 20 MHz unter Wiederholung des Verfahrens 4 durch.
   - Die gespeicherte Information, sowohl des vollständigen Spektrums als auch des Spektrums im Zoom-Modus, die durch den Block 2 erhalten sind, die Spektralinformation, wird zu ihrer Anzeige auf dem Anzeigenblock 7 an den Mikroprozessor gesendet.
   - Darstellung der gesamten Information simultan auf derselben Anzeige-Einheit 7, wie in Figur 2 gezeigt:
      71 Anzeige des eingestellten Kanals.
      72 Anzeige der Spektraleigenschaften des eingestellten Signals und der Nachbarkanäle mit einer Bandbreite von 20 MHz für terrestrisches Band und 50 MHz für Satellitenband.
      73 Anzeige der Spektraleigenschaften des vollständigen radioelektrischen Spektrums gemäß der ausgewählten Bandbreite.

### Bezugszeichenliste

- E: Gerät
- 1: HF-Block
- 2: digitaler Verarbeitungsblock
- 4: Mikroprozessor oder Mikrocontroller
- 5: Batteriesystem
- 6: Benutzeroberfläche
- 7: Sichtanzeige-Einheit (Display)
- 71: Anzeige der Information über den eingestellten Kanal und Messungen
- 72: "Zoom"-Anzeige der Spektraleigenschaften des eingestellten Signals und der Nachbarkanäle
- 73: Anzeige der Bandbreitenspektraleigenschaften gemäß Parametern
- 8: Demodulator

## Patentansprüche

1. Gerät (E) zum Messen von Rundfunk- und/oder TV-Signalen, das Messungen von verschiedenen TV-Signalarten, insbesondere von DVBT-, DVBC-, DVBS- und/oder DVBS2-Signalen, durchführt,
**dadurch gekennzeichnet,**
**dass** es Visualisierungs-Mittel aufweist, die eine simultane Visualisierung mehrerer Anzeigen (71, 72, 73), insbesondere eines radioelektrischen Spektrums von TV-Kanälen, insbesondere von DVBT-, DVBC-, DVBS- und/oder DVBS2-Signalen, im Bereich zwischen 5 MHz und 2,5 GHz und weiterhin des Spektrums eines eingestellten Signals und seiner Nachbarkanäle mit einer Bandbreite von 20 MHz für terrestrisches Band und 50 MHz für Satellitenband auf genau einer Sichtanzeige-Einheit (7) durchführen.

2. Gerät zum Messen von Rundfunk- und/oder TV-Signalen nach Anspruch 1, **dadurch gekennzeichnet, dass** die Visualisierungs-Mittel zumindest eine HF-Einheit (1), die insbesondere ein Eingangssignal, insbesondere DVBT-, DVBC-, DVBS- und/oder DVBS2-Signale wiederherstellt und in ein Frequenzband transformiert, das sich vom Eingangsfrequenzband unterscheidet, einen digitalen Prozessor (2), der eine Spektralantwort nach einem vorgebbaren Spektralberechnungsverfahren berechnet, einen Demodulator (8), einen Mikroprozessor (4) und einen Speicher (3) umfassen.

3. Gerät zum Messen von Rundfunk- und/oder TV-Signalen nach einem der vorhergehenden Ansprüche, **dadurch gekennzeichnet, dass** es ein Batteriesystem (5) aufweist, das das Gerät versorgt.

4. Verfahren zum Messen von Rundfunk- und Fernsehsignalen zur Durchführung von Messungen von verschiedenen TV-Signalarten, insbesondere von DVBT-, DVBC-, DVBS- und/oder DVBS2-Signalen,
**dadurch gekennzeichnet,**
**dass** es Messungen von verschiedenen TV-Signalarten, insbesondere von DVBT-, DVBC-, DVBS- und/oder DVBS2-Signalen, durchführt,
**dass** es eine simultane Visualisierung mehrerer Anzeigen (71, 72, 73), insbesondere eines radioelektrischen Spektrums von TV-Kanälen insbesondere der DVBT-, DVBC-, DVBS- und/oder DVBS2-Signale, im Bereich zwischen 5 MHz und 2,5 GHz und weiterhin eines Spektrums eines eingestellten Kanals und seiner Nachbarkanäle mit einer Bandbreite von 20 MHz für terrestrisches Band und 50 MHz für Satellitenband auf genau einer Sichtanzeige-Einheit (7) durchführt.

5. Verfahren zum Messen von Rundfunk- und Fernsehsignalen nach Anspruch 4, mit einem Gerät nach Anspruch 2, **dadurch gekennzeichnet, dass** das Spektralberechnungsverfahren zumindest folgende Schritte umfasst:
• Auswahl eines Kanals und von Parametern, insbesondere von Parametern von Bildschirmbreiten, die dargestellt werden sollen und welche vom Benutzer eingegeben werden;
• Auswählen einer Untersuchungsart, die ausgeführt werden soll, im Spektrummodus unter Differenzierung zwischen analog und digital, sowie Auswählen eines Bezugspegels, gegebenenfalls einer Bandbreite;
• Verarbeiten des HF-Signals und Durchführen einer Umsetzung auf Zwischenfrequenz (ZF) und Eingeben in den digitalen Prozessor (2), der eine Spektralantwort berechnet, und den Demodulator (8);
• Unter Verwendung eines von der HF-Einheit (1) zur Verfügung gestellten Signals Sampeln und Umsetzen auf digital durch den digitalen Prozessor (2), unter Anwendung von digitalen Verarbeitungstechniken, insbesondere eines Fourier-Algorithmus, DFT, in Echtzeit, sowie Speichern der Information in dem Speicher (3);
• Steuern der HF-Einheit (1) durch den Mikroprozessor (4) zur Ausführung der Frequenzumsetzung der vom Benutzer ausgewählten Bandbreite in Sprüngen von insbesondere 20 MHz unter Wiederholung des Verfahrens nach Anspruch 4.
• Senden der vom digitalen Prozessor (2) gebildeten, gespeicherten Spektralinformation, sowohl des vollständigen Spektrums als auch des Spektrums im Zoom-Modus, zu ihrer Anzeige auf der Sichtanzeige-Einheit (7) an den Mikroprozessor (4).
